# EUROPEAN PATENT APPLICATION

(11) **EP 4 181 218 A1**
(43) Date of publication of application: **17.05.2023**
(21) Application number: 21383016.9
(22) Date of filing: 10.11.2021
(51) Int. Cl.: H01L 31/048, H02S 10/20, H02S 40/38, H01G 11/08

(54) **PHOTOVOLTAIC ASSEMBLY**

(71) Applicant: Soltec Innovations, S.L., 30500 Molina de Segura (ES)
(72) Inventor: Chaouki Almagro, Samir, 30500 Molina de Segura (ES); Carpio Obre, Francisco Javie, 30500 Molina de Segura (ES); Teruel Hernández, Jose Alfonso, 30500 Molina de Segura (ES)
(74) Representative: Isern Patentes y Marcas S.L.

(57) **Abstract**

It comprises one or several capacitors (3) laminated or encapsulated together with at least one photovoltaic arrangement including one or several photovoltaic solar cells (8), preferably comprising one or several photovoltaic solar panels (2), which are made of solar cells (8). In a preferred embodiment, the solar panel (2) includes: frame (4); laminated or encapsulated block (5) housed within the frame (4), and comprising photovoltaic solar cells (8); and capacitor (3); the capacitor (3) being attached to a back side of the photovoltaic solar panel (2); the laminated or encapsulated block (5) and the capacitor (3) being housed within the frame (4); the laminated or encapsulated block (5), and the capacitor (3) being laminated or encapsulated together. The invention provides a photovoltaic arrangement, such as a panel (2), operating as a decentralized energy accumulator, thereby eliminating the use of chemical batteries while providing an integrated energy-storing solution.

## Description

### Technical field of the invention

The present invention may be included within the technical field of solar energy. In particular, the object of the invention relates to a photovoltaic assembly comprising a capacitor which is laminated together with a solar arrangement comprising one or several photovoltaic solar cells.

### Background of the invention

The photovoltaic solar panels of a photovoltaic installation are made through a process including a lamination step, in which the already-connected photovoltaic cells are laminated, together with other layers. The layers usually comprise: front and back encapsulating layers, usually made of EVA (Ethylene-vinyl acetate), wherein, along this document "front" is to be understood as "facing the Sun", whereas "back" is to be understood as "facing the ground"; a back sealing layer, such as made of Polyvinyl fluoride (PVF), commercially known asTedlar, for tight-sealing the panel; and a front protection layer, such as made of glass, preferably low-iron-content tempered glass. A usual arrangement of the layers and the cells is, from front to back: protecting layer, front encapsulating layer, cells, back encapsulating layer and sealing layer.

During the lamination step, the cells and the layers are compacted together, without leaving air within, by means of laminating machines, which work through a heating, vacuum and pressure cycle. In particular, the cells and the layers are arranged as described above, on a platform, and a lid of the laminating machine is closed, so that a sandwich is made. Progressively, vacuum is made and, simultaneously, the platform is heated (up to around 100 °C). When a predefined vacuum level is reached, the sandwich is pressed by a diaphragm for obtaining a solid, tight-sealed laminated assembly. Then, an aluminum frame is mounted around the laminated assembly, so as to finish the solar panel.

In a photovoltaic installation, the electricity provided by the cells of the photovoltaic panel is usually stored for later use or for transferring the electricity to a grid. Solutions for storing the energy may include chemical batteries, capacitors or a combination of both.

### Summarized description of the invention

The present invention relates to a photovoltaic assembly comprising one or several capacitors laminated, or encapsulated, together with an arrangement, the arrangement including one or several photovoltaic solar cells, such as individual cells, or at least one solar panel. In particular, the invention may comprise one photovoltaic solar panel (which includes solar cells), encapsulated, or laminated, together with one or several capacitors. Also, the invention may comprise several photovoltaic solar panels, each one being laminated or encapsulated together with one or several capacitors.

According to a more general aspect of the invention, the photovoltaic assembly comprises one or several capacitors laminated or encapsulated together with at least one photovoltaic arrangement including one or several photovoltaic solar cells.

In a first preferred embodiment, the capacitors may consist of one capacitor, and the photovoltaic arrangement may consist of one photovoltaic solar cell or may comprise several photovoltaic solar cells connected to each other in series and / or in parallel. In a second preferred embodiment, the photovoltaic arrangement may consist of one photovoltaic solar cell, and the capacitors may consist of one capacitor, or may comprise several capacitors connected to each other in series and / or in parallel. In a third embodiment, the capacitors may comprise several capacitors, connected to each other in series and / or in parallel, and the photovoltaic arrangement may consist of several photovoltaic solar cells connected to each other in series and / or in parallel. In a fourth embodiment, the capacitors may comprise several capacitors, and the photovoltaic arrangement may consist of several photovoltaic solar cells, wherein one or several interconnected solar cells are laminated, or encapsulated, together with one or several capacitors.

The photovoltaic assembly of the invention may operate as a decentralized energy accumulator, be it for energy storing or also as a back-up for a controller of a solar tracker to which the assembly is mounted. However, the invention is applicable to any kind of photovoltaic solar arrangement, not limited to those mounted on solar trackers.

The assembly of the invention allows taking advantage of the above-referred solar panel production process for integrating a capacitor-type energy-storing system. The invention eliminates the necessity of using chemical batteries while providing an integrated energy-storing solution.

The invention is applicable to any kind of use in which photovoltaic panels and energy-storing systems coexist.

The invention allows for avoiding chemical batteries, external power sources and battery substitution.

### Brief description of the drawings

All preceding, as well as other, features and advantages, shall be better understood in the light of the following detailed description of preferred embodiments of the invention, with reference to the attached drawings, which are to be considered for illustrative, non-limiting purposes, and wherein:
- Figure 1 shows a schematic section view of the assembly according to one preferred embodiment of the invention.
- Figure 2 shows a schematic diagram of another preferred embodiment of the invention.
- Figure 3 shows a schematic view of a preferred embodiment comprising one capacitor which is laminated or encapsulated together with one single photovoltaic solar cell.

### Detailed description of a preferred embodiment of the invention

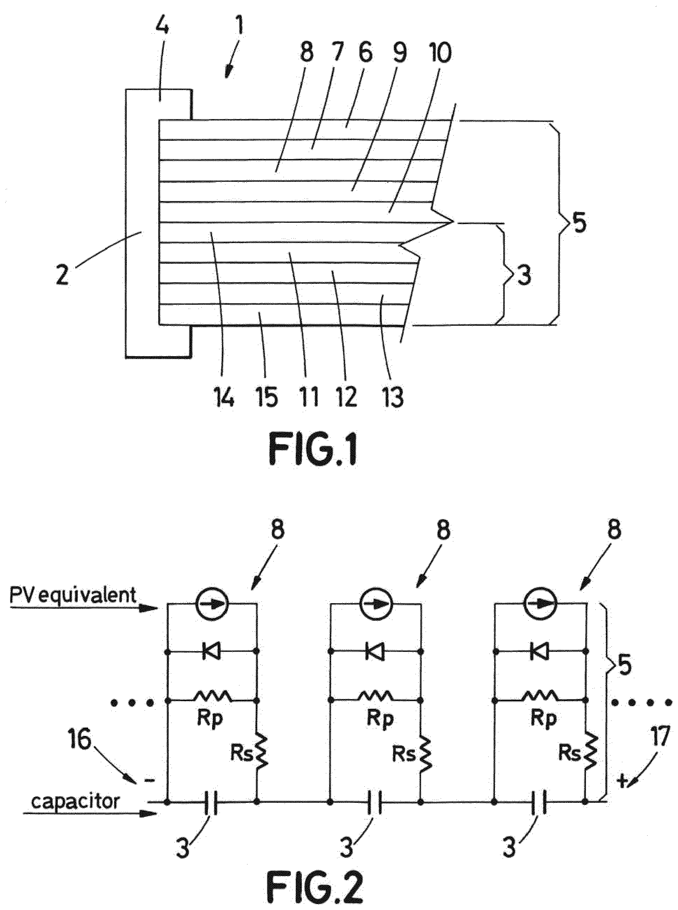

Next, a detailed description of preferred embodiments of the invention is provided with the help of above-mentioned figures 1-2.

The preferred embodiment of the invention features a photovoltaic assembly (1) comprising: an arrangement including at least one photovoltaic solar cell (8), such as single photovoltaic cells (8) or at least one photovoltaic panel (2); and at least one capacitor (3), wherein the at least one capacitor (3) is laminated, or encapsulated, together with an arrangement, such as the photovoltaic solar panel (2), as explained below by way of an example. The invention also relates to a solar installation comprising one or several of the assemblies (1) referred to above. Each assembly (1) may comprise several photovoltaic solar panels (2), each of them being laminated, or encapsulated, together with one or several capacitors (3). In the exemplary preferred embodiment described below in a non-limitative way, the assembly (1) only comprises one photovoltaic solar panel (2) and only one capacitor (3), for the sake of conciseness.

As mentioned above, see figure 1, the photovoltaic solar panel (2) may comprise, as is common in the state of the art, a frame (4), such as aluminum frame (4), housing a laminated, or encapsulated, block (5) including the following components arranged as described below: protecting layer (6), such as made of glass, preferably low-iron-content tempered glass; front encapsulating or laminating layer (7), such as made of EVA; photovoltaic cells (8); back encapsulating or laminating layer (9), such as made of EVA; and sealing layer (10), such as made of Polyvinyl fluoride (PVF), for instance comprising three layers made of Tedlar (PVF), polyester and Tedlar (PVF).

As explained above, the assembly of the invention further comprises a capacitor (3), including a conductive positive layer (11), a dielectric layer (12) and a conductive negative layer (13). The capacitor (3) may be covered by a front isolating layer (14) and a back isolating layer (15).

The assembly (1) is characterized in that at least one of the capacitors (3) is housed within the frame (4); wherein at least one of the capacitors (3) is laminated or encapsulated together with at least one of the laminated blocks (5), so that at least one of said capacitors (3) is comprised as part of said laminated or encapsulated block (5), as shall be explained below through the description of several preferred embodiments.

According to a first preferred embodiment, one single solar cell (8) may be encapsulated or laminated together with one capacitor (3), wherein the voltage born by the capacitor (3) shall be that provided by the solar cell (8), wherein at least one of the laminated or encapsulated blocks (5) comprises one solar cell (8) laminated or encapsulated together with one capacitor (3). In particular, each single solar cell (8) may be laminated or encapsulated together with one corresponding capacitor (3), as shown on figure 2.

According to a second preferred embodiment, a plurality of the solar cells (8) is laminated or encapsulated together with one capacitor (3), wherein the solar cells (8) may be connected to each other in series or in parallel or in a combination of both, such that the voltage to which the capacitor (3) is subjected is the voltage provided by the plurality of solar cells (8) together.

According to a third preferred embodiment, see also figure 1, all the solar cells (8) of the panel are laminated or encapsulated together, as a whole, with one capacitor (3), so that the voltage born by the capacitor (3) shall be that provided by the panel (2).

Preferably, the capacitor (3) is located at a back side of the frame (4); in particular, the capacitor (3) is attached to the back side of the frame (4).

The capacitor (3), or each capacitor (3), may be assembled apart, and then included in a lamination step or encapsulation step of the laminated or encapsulated block (5). Alternatively, all layers (6, 7, 8, 9, 10, 14, 15) of the capacitor (3) may be put together so as to be laminated or encapsulated together with all parts of the laminated block (5).

According to figure 2, the laminated or encapsulated block (5) may further comprise, as is usual in the state of the art, fingers (16) for recovering the electricity produced by the photovoltaic cells (8), as well as buses (17) for directing the electricity from the fingers (16) to a grid or to an energy storing means. In particular, the buses (17) may be connected to the capacitor (3) for loading the capacitor (3). For instance, the cells (8) comprise electrical connections which are connected in parallel to terminals of the capacitor (3). Additionally, a control unit (18) may perform control functions, such as: controlling loading and unloading of the capacitor (3); equalizing capacitor voltages, in case that several panels (2) are connected in series, which means also a series connection of the capacitors (3).

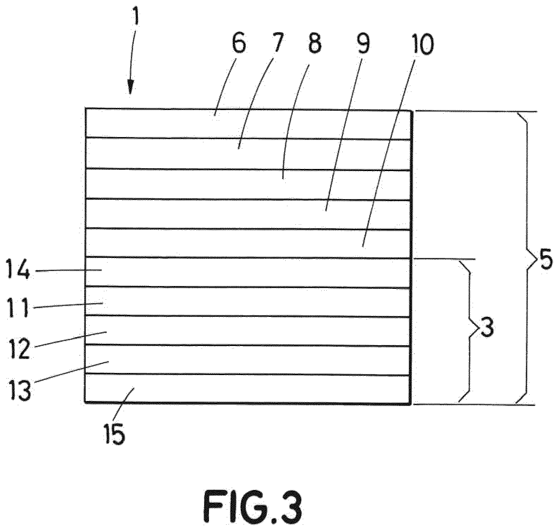

Figure 3 relates to a particular embodiment wherein the photovoltaic assembly (1) comprises an arrangement of only one solar cell (8), which is encapsulated or laminated together with one single capacitor (3). In particular, and similar to what has been explained above, the arrangement comprises a laminated, or encapsulated, block (5) including the following components: protecting layer (6); front encapsulating or laminating layer (7); the photovoltaic cell (8); back encapsulating or laminating layer (9); and sealing layer (10). The capacitor (3), similar to as explained above, includes: conductive positive layer (11), dielectric layer (12) and conductive negative layer (13). The capacitor (3) may be covered by a front isolating layer (14) and a back isolating layer (15).

## Claims

1. Photovoltaic assembly (1), **characterized by** comprising one or several capacitors (3) laminated or encapsulated together with at least one photovoltaic arrangement, the arrangement including one or several photovoltaic solar cells (8).

2. Photovoltaic assembly (1), according to claim 1, wherein the capacitors (3) consist of one capacitor (3), and the photovoltaic arrangement consists of one photovoltaic solar cell (8) or comprises several photovoltaic solar cells (8) connected to each other in series and / or in parallel.

3. Photovoltaic assembly (1), according to claim 1, wherein the photovoltaic arrangement consists of one photovoltaic solar cell (8) and the capacitors (3) consist of one capacitor (3) or comprise several capacitors (3) connected to each other in series and / or in parallel.

4. Photovoltaic assembly (1), according to claim 1, wherein the capacitors (3) comprise several capacitors (3), connected to each other in series and / or in parallel, and the photovoltaic arrangement consists of several photovoltaic solar cells (8) connected to each other in series and / or in parallel.

5. Photovoltaic assembly (1), according to claim 1, wherein the capacitors (3) comprise several capacitors (3), and the photovoltaic arrangement consists of several photovoltaic solar cells (8), wherein one or several interconnected solar cells (8) are laminated or encapsulated together with one or several capacitors (3).

6. Photovoltaic assembly (1), according to claim 1, wherein the arrangement comprises a photovoltaic solar panel (2).

7. Photovoltaic assembly (1), according to claim 6, wherein the solar panel (2) comprises:
- a frame (4);
- at least one laminated or encapsulated block (5), housed within the frame (4), and comprising the photovoltaic arrangement; and
- the capacitor (3) or capacitors (3);
wherein at least one of the capacitors (3) is housed within the frame (4);
wherein at least one of the capacitors (3) is laminated or encapsulated together with at least one of the laminated or encapsulated blocks (5), so that at least one of said capacitors (3) is comprised as part of said laminated or encapsulated block (5).

8. Photovoltaic assembly (1) according to claim 7, further comprising a front isolating layer (14) and a back isolating layer (15), covering the capacitor (3).

9. Photovoltaic assembly (1) according to claim 7, wherein the capacitor (3) is located at a back side of the frame (4).

10. Photovoltaic assembly (1) according to claim 8, wherein the capacitor (3) is attached to the back side of the frame (4).

11. Photovoltaic assembly (1) according to anyone of claims 7-10, wherein the laminated block (5) further comprises:
- fingers (16) for recovering the electricity produced by the photovoltaic cells (8); and
- buses (17), connected to the capacitor (3), for directing the electricity from the fingers (16) to the capacitor (3).

12. Photovoltaic assembly (1) according to anyone of claims 7-11, wherein the cells (8) further comprise electrical connections which are connected in parallel to terminals of the capacitor (3).

13. Photovoltaic assembly (1) according to anyone of claims 7-12, wherein assembly (1) comprises several photovoltaic solar panels (2), each of them being laminated or encapsulated together with one or several capacitors (3).

14. A solar installation **characterized by** comprising one or several assemblies (1) as described in anyone of claims 7-13.
